# EUROPÄISCHE PATENTSCHRIFT

(11) **EP 3 399 549 B1**
(45) Veröffentlichungstag und Bekanntmachung des Hinweises auf die Patenterteilung: **02.07.2025**
(21) Anmeldenummer: 18169300.3
(22) Anmeldetag: 25.04.2018
(51) Int. Cl.: H01L 25/07, H01L 23/00, H01L 23/367, H01L 23/433, H01L 23/498

(54) **HALBLEITERMODUL**
SEMI-CONDUCTOR MODULE
MODULE SEMI-CONDUCTEUR

(30) Priorität: 05.05.2017 DE 102017207565
(43) Veröffentlichungstag der Anmeldung: 07.11.2018
(73) Patentinhaber: Robert Bosch GmbH, 70442 Stuttgart (DE)
(72) Erfinder: Nitsche, Heiko, 72770 Reutlingen (DE); Hirschle, Johannes, 72537 Mehrstetten (DE); Strache, Sebastian, 72762 Reutlingen (DE); Betz, Volker, 72116 Moessingen (DE)

(56) Entgegenhaltungen:
- EP-A1- 3 065 172
- DE-A1- 102009 006 152
- US-A1- 2014 008 781
- US-A1- 2014 110 776
- US-A1- 2014 306 332

## Beschreibung

Die Erfindung geht aus von einem Halbleitermodul nach der Gattung des unabhängigen Patentanspruchs 1.

Aus dem Stand der Technik sind als integrierte Halbbrückenschaltungen (B2) in Moldgehäusen ausgeführte Halbleitermodule bekannt, welche beispielsweise als "leadless Chip-Scale-Packages" (anschlussloses Gehäuse in der Größenordnung eines Dies) aufgebaut sind. Diese Bauform ist beispielsweise zum Aufbau leistungselektronischer Pulswechselrichterbaugruppen auf Leiterplatten bestimmt. Das Moldgehäuse schließt bündig mit exponierten Oberflächen von Leadframes ab, mit welchen die Halbbrückenschaltung auf die Leiterplatte gelötet ist. In dieser "anschlusslosen"-Bauweise erstrecken sich die Leadframes der Halbbrückenschaltungen nicht über die Außenberandungen des Moldgehäuses hinaus. Die Halbbrückenschaltung umfasst zwei Transistoren, welche innerhalb eines Gehäuses jeweils zwischen zwei Trägern angeordnet und mit den Trägern elektrisch leitend verbunden sind. Ströme aus der Halbbrückenschaltung fließen über die Leiterplatte und erzeugen dort in unmittelbarer Umgebung der exponierten Oberflächen der Leadframes hohe Verlustleistungsdichten. Der in den Schaltungsträger eingeleitete Phasenstrom der Halbbrückenschaltung wird dort mittels eines Abgriffs mit dem Phasenstromdraht verbunden, welcher in eine Statorwicklung einer angeschlossenen elektrischen Maschine übergeht.

Zudem sind Leistungshalbleitermodule bekannt, welche in sogenannten "Moldpackages" (Moldgehäusen) verbaut sind. Die Kontaktierung erfolgt über seitliche Kontaktbeinchen (z.B. SOIC Gehäuse oder DPAK/LFPAK) oder über Kontaktflächen an der Unterseite (z.B. QFN). Die thermische Entwärmung kann über die Unterseite oder die Oberseite oder beidseitig erfolgen. Bei den aufgeführten Packages werden die Leistungshalbleiter nur in einer Kontaktebene verbaut, d.h. alle zur Verschaltung notwendigen Kontakte müssen in dieser Ebene auf dem Trägersubstrat für den weiteren Verbau berücksichtig werden. Hieraus können sich beim Schaltungsentwurf Nachteile für Flächenbedarf, Entwärmung und Strombelastbarkeit ergeben.

Aus der DE 10 2009 006 152 A1 ist ein Elektronikbauelement bekannt, welches einen Träger, einen ersten Hableiterchip, einen zweiten Halbleiterchip und einen metallischen Clip umfasst, welche von einem Moldgehäuse umgeben sind. Der erste Halbleiterchip ist mit einer ersten Oberfläche auf dem Träger aufgebracht. Der metallische Clip ist S-förmig gebogen und verbindet eine zweite Oberfläche des ersten Halbleiterchips, welche der ersten Oberfläche gegenüberliegt, mit einer ersten Oberfläche des zweiten Halbleiterchips, wobei die erste Oberfläche des zweiten Halbleiters in einer anderen Ebene des Elektronikbauelements angeordnet ist. Eine zweite Oberfläche des zweiten Halbleiterchips kann mit einem zweiten metallischen Clip verbunden werden. Die metallischen Clips können durch Stanzen, Prägen, Pressen, Schneiden, Sägen, Fräsen hergestellt werden. Der S-förmige metallische Clip kann beispielsweise eine Strombrücke zwischen einem Drain-Potential eines ersten, Low-Side-Transistors und einem Source-Potential eines zweiten, High-Side-Transistors in einer Halbbrückenschaltung herstellen.

Zudem zeigt Dokument US 2014/110776 A1 ein Halbleitermodul, das dem Oberbegriff des Anspruchs 1 entspricht.

### Offenbarung der Erfindung

Das Halbleitermodul mit den Merkmalen des unabhängigen Patentanspruchs 1 hat den Vorteil, dass beispielsweise durch ein sogenanntes FAM (Film Assisted Molding) auf der Oberfläche des Gehäuses Kontaktflächen freigestellt und nach dem Moldprozess bei der Weiterverarbeitung thermisch, elektrisch und mechanisch kontaktiert werden können. Die freigestellten Kontaktflächen haben über einen thermisch und elektrisch leitenden Verbindungsclip Kontakt zu den verbauten Halbleiterbauelementen. Hierdurch entsteht ein neuer Pfad, über welchen Strom und Wärme fließen kann.

Das erfindungsgemäße Halbleitermodul ist als Halbbrückenschaltung ausgeführt. In vorteilhafter Weise können Ausführungsformen des erfindungsgemäßen Halbleitermoduls für den Aufbau auf einem elektronischen Schaltungsträger vorgesehen werden, welcher mit einer elektrischen Maschine unmittelbar zu einem "Power-Pack" zusammengesetzt ist. In vorteilhafter Weise kann ein Phasenpotentialabgriff der korrespondierenden Halbbrückenschaltung unmittelbar mit einem Phasenstromdraht einer Statorwicklung der elektrischen Maschine verbunden werden, ohne den Phasenstrom durch den Schaltungsträger zu führen, auf welchem das Halbleitermodul angeordnet ist.

Ausführungsformen des erfindungsgemäßen Halbleitermoduls können grundsätzlich für alle Package-Typen und Technologien (Standard, Lead-less, PCB-Embedding) eingesetzt werden. Durch Drehen bzw. Flippen des ersten Halbleiterbauteils erfolgt ein korrespondierender Stromfluss im Substrat bzw. innerhalb des Gehäuses ausschließlich in vertikaler Richtung, daher können auch weniger hochstromgeeignete Substrate wie LP-Material verwendet werden. Zudem können für Ausführungsformen des erfindungsgemäßen Halbleitermoduls auch kostengünstige LGA- und/oder BGA-Packages eingesetzt werden, da durch die freiliegende Kontaktstelle des Verbindungsclips eine Slug-up-Kühlung außerhalb des Gehäuses erfolgt und im Substrat keine Entwärmungsfunktion erforderlich ist.

Zudem entfällt durch den außerhalb des Gehäuses geführten Strompfads in vorteilhafter Weise der Wärmeeintrag mit hoher Verlustleistungsdichte im Inneren des Halbleitermoduls und die damit einhergehenden Zuverlässigkeitsrisiken durch Delamination des Moldgehäuses, Lotstellenbrüche, Bondabrisse usw. Ausführungsformen des vorgeschlagenen Halbleitermoduls weisen im Inneren keine Stromeinschnürungen auf und sind demzufolge elektrisch und thermisch wesentlich höher belastbar bei zumindest gleicher Zuverlässigkeit und Lebensdauer wie vergleichbare Leistungshalbleitermodule herkömmlicher Bauart.

Ausführungsformen der vorliegenden Erfindung stellen ein Halbleitermodul mit mindestens zwei Halbleiterbauteilen zur Verfügung, welche jeweils eine innerhalb eines Gehäuses auf einem Träger angeordnete aktive Halbleiterschicht aufweisen, wobei ein Strompfad zwischen den mindestens zwei Halbleiterbauteilen mittels eines metallischen Verbindungsclips ausgebildet ist, welcher eine erste Elektrode eines ersten Halbleiterbauteils mit einer zweiten Elektrode eines zweiten Halbleiterbauteils verbindet. Hierbei sind das erste Halbleiterbauteil und das zweite Halbleiter um 180° gedreht zueinander auf dem Träger angeordnet, so dass die erste Elektrode des ersten Halbleiters und die zweite Elektrode des zweiten Halbleiters in einer gemeinsamen Ebene angeordnet und jeweils mit einer ersten Clipseite des metallischen Verbindungsclips elektrisch verbunden sind. Zudem bildet eine zweite Clipseite des Verbindungsclips eine freiliegende Kontaktstelle aus. Bevorzugt schließt dabei die freiliegende Kontaktstelle eben mit einer ersten Oberfläche des Gehäuses ab.

Erfindungsgemäß bildet ein Kontaktelement außerhalb des Gehäuses einen zusätzlichen Hochstrompfad und Wärmepfad aus. Das Kontaktelement hat eine Kontaktfläche, die über eine elektrische leitende Verbindungsschicht mit der freiliegenden Kontaktstelle des Verbindungsclips verbunden ist.

Zudem werden durch die Einbringung von dem Kontaktelement ein Teil der Kontakte aus der o.g. Kontaktebene entfernt. Hieraus ergeben sich beim Schaltungsentwurf Vorteile für den Flächenbedarf, Entwärmung und Strombelastbarkeit.

Erfindungsgemäß ist das erste Halbleiterbauteil als Low-Side- Schalttransistor und das zweite Halbleiterbauteil als High-Side-Schalttransistor der Halbbrückenschaltung ausgeführt, wobei erste Elektroden der Halbleiterbauteile als Drain-Elektroden, zweite Elektroden der Halbleiterbauteile als Source-Elektroden und dritte Elektroden der Halbleiterbauteile als Gate-Elektroden ausgeführt werden.

Durch die in den abhängigen Ansprüchen aufgeführten Maßnahmen und Weiterbildungen sind vorteilhafte Verbesserungen des im unabhängigen Patentanspruch 1 angegebenen Halbleitermoduls möglich.

Das Kontaktelement kann eine der Kontaktstelle abgewandte Entwärmungsfläche aufweisen, welche mit einem Kühlkörper verbunden werden kann. In vorteilhafter Weise kann das Kontaktelement durch seine dreidimensionale Ausdehnung eine als thermischer Speicher wirkende Wärmesenke ausbilden. Das Kontaktelement ist dicker als der Verbindungsclip ausgeführt und weist ein Volumen auf, das um den Faktor 5 bis 50 größer als das Volumen des Verbindungsclips ist. Durch das zusätzliche thermische Speichervolumen des Kontaktelements können gepulste Wärmeströme in Gleichstromwärmestrom umgewandelt werden, so dass eine höhere Entwärmungsleistung umgesetzt werden kann. Durch die Dicke des Kontaktelements erfolgt zusätzlich eine Wärmespreizung, so dass für den Wärmetransport durch das elektrisch nicht leitende Wärmeleitmedium eine größere Fläche zur Verfügung steht.

Das Kontaktelement weist in vorteilhafter Weise eine Entwärmungsfläche auf, welche über ein elektrisch nicht leitendes Wärmeleitmedium an einen Kühlkörper angebunden werden kann.

In vorteilhafter Ausgestaltung des Halbleitermoduls kann das Kontaktelement einen Kontaktierbereich aufweisen, welcher seitlich über das Gehäuse überstehen und mit einem elektrischen Leiter kontaktiert werden kann. Dadurch kann in vorteilhafter Weise außerhalb des Gehäuses eine Hochstromschnittstelle ausgebildet werden, an welcher ein Endbereich des elektrischen Leiters mittels Löten, Widerstands- oder Laserschweißen, Schneid-Klemmung, Crimpen oder Einpressverbinden mit dem Kontaktierbereich verbunden werden kann. Selbstverständlich können auch andere geeignete Verbindungstechniken eingesetzt werden, um den Kontaktierbereich elektrisch mit dem elektrischen Leiter zu verbinden und den korrespondierenden Hochstrompfad auszubilden.

In weiterer vorteilhafter Ausgestaltung des Halbleitermoduls kann die Form der Kontaktfläche des Kontaktelements an die Form der freiliegenden Kontaktstelle der zweiten Clipseite des Verbindungsclips angepasst werden, um einen optimierten Strom- und Wärmeübergang zu ermöglichen.

In alternativer Ausgestaltung des Halbleitermoduls kann ein abgewinkelter Endbereich eines elektrischen Leiters das Kontaktelement ausbilden und unter Berücksichtigung von Zugentlastung und Montagetoleranzen über eine dauerfeste Verbindungstechnologie direkt mit der Kontaktstelle elektrisch verbunden werden.

In weiterer vorteilhafter Ausgestaltung des Halbleitermoduls kann das Gehäuse als Moldgehäuse ausgeführt werden. Dies ermöglicht eine kostengünstige Herstellung des Halbleitermoduls.

In weiterer vorteilhafter Ausgestaltung des Halbleitermoduls können die mindestens zwei Halbleiterbauteile als Leistungshalbleiterbauteile ausgeführt werden, welche den gleichen Flächenbedarf aufweisen und eine Halbbrückenschaltung für eine elektrische Maschine ausbilden. In vorteilhafter Weise kann dann ein Phasenstromdraht einer elektrischen Maschine den elektrischen Leiter ausbilden.

Die Halbleiterbauteile können beispielsweise als IGBTs (Insulated Gate Bipolar Transistors), MOSFET (Metal-Oxide-Semiconductor Field-Effect Transistor, Metall-Oxid-Halbleiter-Feldeffekttransistor), usw. ausgeführt werden.

In weiterer vorteilhafter Ausgestaltung des Halbleitermoduls können mehrere intelligente Leistungsbausteine wie MOSFETs mit Treiber-ASIC und Multichippackages mit mehreren Motorphasen (Halbbrücke, B6-Brücke, auch 2, 4, 5,... Halbbrücken) in einem Halbleitermodul kombiniert werden. So können beispielsweise drei Halbleiterbauteilpaare, welche jeweils aus einem ersten Halbleiterbauteil als Low-Side-Schalttransistor und einem über den metallischen Verbindungsclip elektrisch mit dem ersten Halbleiterbauteil verbundenen zweiten Halbleiterbauteil als High-Side-Schalttransistor bestehen, ein Brückenschaltungsmodul für drei Phasenstromdrähte einer elektrischen Maschine ausbilden. In weiterer vorteilhafter Ausgestaltung des Halbleitermoduls kann das Gehäuse an seiner ersten Oberfläche mit einem Kühlkörper verbunden werden, welcher auf mindestens einer Entwärmungsfläche mindestens eines Kontaktelements aufliegen kann. Zudem kann das Gehäuse an seiner zweiten Oberfläche auf eine Leiterplatte aufgesetzt werden.

Ein Ausführungsbeispiel der Erfindung ist in der Zeichnung dargestellt und wird in der nachfolgenden Beschreibung näher erläutert. In der Zeichnung bezeichnen gleiche Bezugszeichen Komponenten bzw. Elemente, die gleiche bzw. analoge Funktionen ausführen.

### Kurze Beschreibung der Zeichnungen

Fig. 1 zeigt eine schematische perspektivische Darstellung eines Ausschnitts eines Ausführungsbeispiels eines erfindungsgemäßen Halbleitermoduls von oben.
Fig. 2 zeigt eine schematische perspektivische Darstellung des erfindungsgemäßen Halbleitermoduls aus Fig. 1 von unten.
Fig. 3 zeigt eine schematische Teilschnittdarstellung des erfindungsgemäßen Halbleitermoduls aus Fig. 1 und 2.
Fig. 4 zeigt eine schematische perspektivische Darstellung des erfindungsgemäßen Halbleitermoduls aus Fig. 1 bis 3 ohne Kontaktelement.
Fig. 5 zeigt eine schematische perspektivische Darstellung eines Ausschnitts des erfindungsgemäßen Halbleitermoduls aus Fig. 1 bis 4 ohne Gehäuse.
Fig. 6 zeigt eine schematische perspektivische Darstellung eines Kontaktelements des erfindungsgemäßen Halbleitermoduls aus Fig. 1 bis 4 mit einem kontaktierten elektrischen Leiter.

### Ausführungsformen der Erfindung

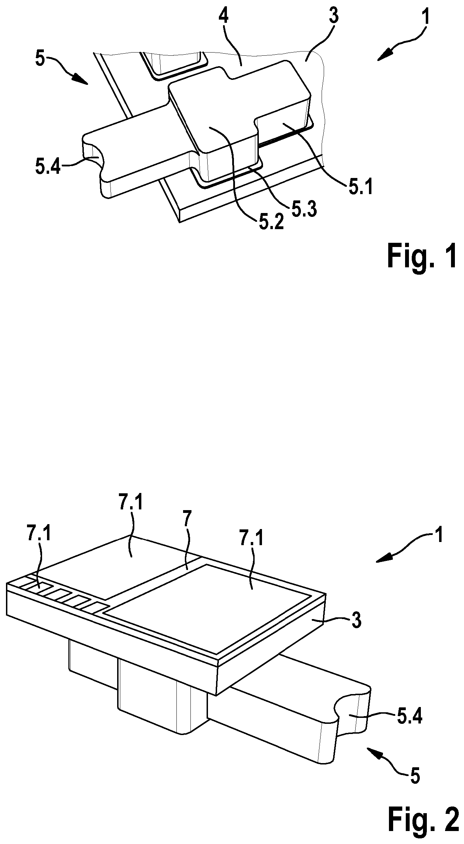

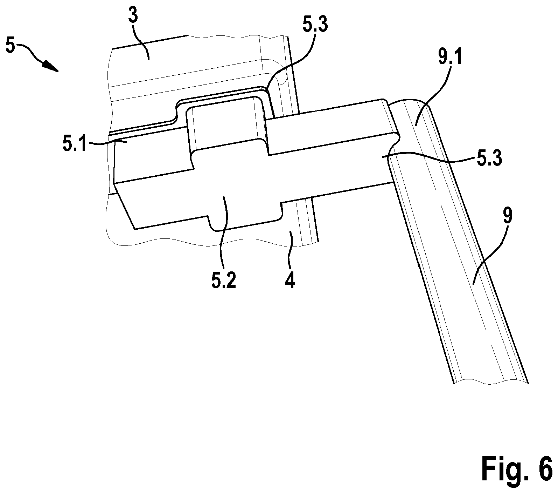

Wie aus Fig. 1 bis 6 ersichtlich ist, umfasst das dargestellte Ausführungsbeispiel eines erfindungsgemäßen Halbleitermoduls 1 mindestens zwei Halbleiterbauteile 10, 20, welche jeweils eine innerhalb eines Gehäuses 3 auf einem Träger 2 angeordnete aktive Halbleiterschicht 12, 22 aufweisen. Zwischen den mindestens zwei Halbleiterbauteilen 10, 20 ist ein Strompfad mittels eines metallischen Verbindungsclips 30 ausgebildet, welcher eine erste Elektrode 14 eines ersten Halbleiterbauteils 10 mit einer zweiten Elektrode 26 eines zweiten Halbleiterbauteils 20 verbindet. Hierbei sind das erste Halbleiterbauteil 10 und das zweite Halbleiter 20 um 180° gedreht zueinander auf dem Träger 2 angeordnet, so dass die erste Elektrode 14 des ersten Halbleiters 10 und die zweite Elektrode 26 des zweiten Halbleiters 20 in einer gemeinsamen Ebene angeordnet und jeweils mit einer ersten Clipseite 32 des metallischen Verbindungsclips 30 elektrisch verbunden sind. Zudem bildet eine zweite Clipseite 34 des Verbindungsclips 30 eine freiliegende Kontaktstelle 4.1 aus, welche eben mit einer ersten Oberfläche 4 des Gehäuses 3 abschließt.

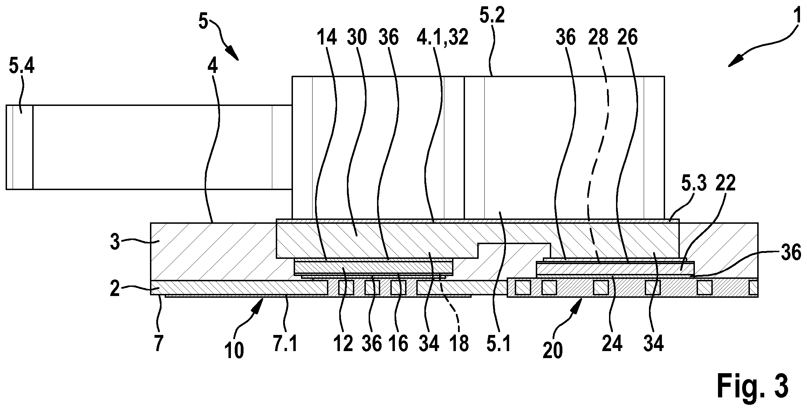

Wie aus Fig. 1 bis 6 weiter ersichtlich ist, bildet ein Kontaktelement 5 außerhalb des Gehäuses 3 einen zusätzlichen Hochstrompfad und Wärmepfad aus und weist eine der Kontaktstelle 4.1 zugewandte Kontaktfläche 5.1 auf. Die Kontaktfläche 5.1 ist über eine elektrische leitende Verbindungschicht 5.3, welche beispielsweise als Lotschicht ausgeführt ist, dauerhaft mit der freiliegenden Kontaktstelle 4.1 der zweite Clipseite 34 verbunden. Das Kontaktelement 5 weist eine der Kontaktstelle 4.1 abgewandte Entwärmungsfläche 5.2 auf, welche mit einem Kühlkörper verbunden werden kann. Wie insbesondere aus Fig. 3 ersichtlich ist, weist das Kontaktelement 5 ein um einen Faktor zwischen 5 bis 50 größeres Volumen als der Verbindungsclip 30 auf. Dadurch bildet das Kontaktelement 5 eine als thermischer Speicher wirkende Wärmesenke aus. Durch das zusätzliche thermische Speichervolumen des Kontaktelements 5 können gepulste Wärmeströme in Gleichstromwärmestrom umgewandelt werden, so dass eine höhere Entwärmungsleistung umgesetzt werden kann.

Das Halbleitermodul 1 kann beispielsweise als dreiphasige B6-Brückenschaltung mit sechs Halbleiterbauelementen 10, 20 für eine nicht dargestellte elektrische Maschine ausgeführt werden. Im dargestellten Ausführungsbeispiel ist aber nur ein Halbleiterbauteilpaar gezeigt, welche jeweils aus einem ersten Halbleiterbauteil 10 als Low-Side-Schalttransistor und einem über den metallischen Verbindungsclip 30 elektrisch mit dem ersten Halbleiterbauteil 10 verbundenen zweiten Halbleiterbauteil 20 als High-Side-Schalttransistor bestehen. Im dargestellten Ausführungsbeispiel sind die Halbleiterbauteile 10, 20 jeweils als MOSFETs (Metal-Oxide-Semiconductor Field-Effect Transistor, Metall-Oxid-Halbleiter-Feldeffekttransistor) ausgeführt, welche den gleichen Flächenbedarf aufweisen. Hierbei sind erste Elektroden 14, 24 der Halbleiterbauteile 10, 20 jeweils als Drain-Elektroden, zweite Elektroden 16, 26 der Halbleiterbauteile 10, 20 sind jeweils als Source-Elektroden und dritte Elektroden 18, 28 der Halbleiterbauteile 10, 20 sind jeweils als Gate-Elektroden ausgeführt. Alternativ können die Halbleiterbauteile 10, 20 beispielsweise auch als IGBTs (Insulated Gate Bipolar Transistors) ausgeführt werden.

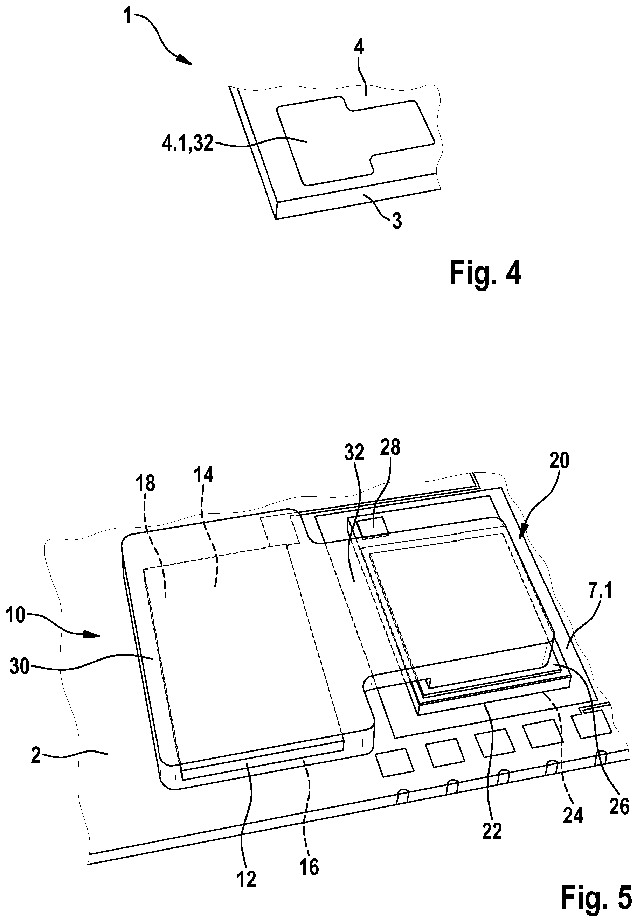

Wie insbesondere aus Fig. 3 und 5 weiter ersichtlich ist, sind die als Low-Side-Schalttransistoren ausgeführten ersten Halbleiterbauteile 10 jeweils Face-down auf dem Träger 2 angeordnet, d.h. die als Source-Elektroden ausgeführten zweiten Elektroden 14 und die als Gate-Elektroden ausgeführten dritten Elektroden 18 der ersten Halbleiterelemente 10 sind dem Träger 2 zugewandt und über elektrisch leitende Verbindungsschichten 36, welche beispielsweise als Lotschichten ausgeführt sind, mit korrespondierenden Kontaktstellen des Trägers 2 verbunden. Diese Kontaktstellen stehen über Durchkontaktierungen im Träger 2 mit freiliegenden Kontaktstellen 7.1 an einer zweiten Oberfläche 7 in Verbindung. Die als Drain-Elektroden ausgeführten ersten Elektroden 14 der ersten Halbleiterbauteile 10 sind jeweils über eine elektrisch leitende Verbindungsschicht 36, welche beispielsweise als Lotschicht ausgeführt ist, mit der ersten Clipseite 32 des Verbindungsclips 30 elektrisch verbunden.

Wie aus Fig. 3 und 5 weiter ersichtlich ist, sind die als High-Side-Schalttransistoren ausgeführten zweiten Halbleiterbauteile 20 jeweils um 180° im Vergleich zu den ersten Halbleiterbauteilen 10 gedreht und Face-up auf dem Träger 2 angeordnet, d.h. die als Drain-Elektroden ausgeführten ersten Elektroden 24 der zweiten Halbleiterbauteile 20 sind dem Träger 2 zugewandt und jeweils über eine elektrisch leitende Verbindungsschicht 36, welche beispielsweise als Lotschicht ausgeführt ist, mit korrespondierenden Kontaktstellen des Trägers 2 verbunden. Diese Kontaktstellen stehen ebenfalls über Durchkontaktierungen im Träger 2 mit freiliegenden Kontaktstellen 7.1 an der zweiten Oberfläche 7 in Verbindung. Die als Source-Elektroden ausgeführten zweiten Elektroden 14 der zweiten Halbleiterelemente 20 sind über elektrisch leitende Verbindungsschichten 36, welche beispielsweise als Lotschichten ausgeführt sind, mit der ersten Clipseite 32 des Verbindungsclips 30 elektrisch verbunden. Die als Gate-Elektroden ausgeführten dritten Elektroden 28 der zweiten Halbleiterbauteile 20 sind beispielsweise über Bonddrähte mit korrespondierenden Kontaktstellen des Trägers 2 verbunden. Diese Kontaktstellen stehen ebenfalls über Durchkontaktierungen im Träger 2 mit freiliegenden Kontaktstellen 7.1 an der zweiten Oberfläche 7 in Verbindung.

Wie aus Fig. 1 bis 6 weiter ersichtlich ist, ist im dargestellten Ausführungsbeispiel nur ein Kontaktelement 5 auf der ersten Oberfläche 4 des Gehäuses 3, d.h. einer Oberseite oder Kühlseite des Halbleitermoduls 1 angeordnet. Neben diesen Kontaktelementen 5 können nicht dargestellte nur als Wärmesenken ausgeführte metallische Blöcke auf der ersten Oberfläche 4 des Gehäuses angeordnet werden. Diese metallischen Blöcke dienen der Wärmeabfuhr von weiteren freiliegenden nicht dargestellten Kontaktflächen, welche nicht durch eine erste Clipseite 32 eines Verbindungsclips 30 ausgebildet werden. Die weiteren freiliegenden Kontaktflächen sind jeweils über eine wärmeleitende Verbindungsschicht mit einer Kontaktfläche der metallischen Blöcke verbunden. Da die Entwärmungsflächen 5.2 der Kontaktelemente 5 in einer gemeinsamen Ebene angeordnet sind, auf welche ein Kühlkörper aufgelegt und über eine elektrisch isolierende aber wärmleitende Verbindungsschicht mit den Entwärmungsflächen 5.2 und den Kontaktelementen 5 verbunden werden kann, gleichen die metallischen Blöcke den Höhenunterschied zwischen den weiteren freiliegenden Kontaktflächen und dem Kühlkörper aus. Somit können auch die Entwärmungsflächen der metallischen Blöcke über eine elektrisch isolierende aber wärmleitende Verbindungsschicht mit dem aufgelegten Kühlkörper verbunden werden. Alternativ kann der Kühlkörper mit einer entsprechenden Auswölbung ausgeführt werden, so dass er gleichzeitig auf den Entwärmungsflächen 5.2 der Kontaktelemente 5 und auf den weiteren freiliegenden Kontaktflächen aufliegen kann. Die Kontaktelemente 5, die metallischen Blöcke und die Verbindungsclips 30 sind vorzugsweise aus Kupfer oder einem anderen geeigneten Material gefertigt.

Im dargestellten Ausführungsbeispiel ist das Gehäuse 3 als Moldgehäuse ausgeführt und kann an seiner ersten Oberfläche 4 mit dem Kühlkörper verbunden werden, welcher auf die Entwärmungsflächen 5.2 der Kontaktelemente 5 und der metallischen Blöcke aufgelegt und mit diesen verbunden werden kann, wie oben ausgeführt ist. Das Gehäuse 3 kann mit seiner zweiten Oberfläche 7, d.h. mit einer Unterseite oder Leiterplattenseite des Halbleitermoduls 1, auf eine nicht dargestellte Leiterplatte aufgesetzt werden. Hierbei werden die an der zweiten Oberfläche 7 freiliegenden Kontaktstellen 7.1 mit korrespondierenden Kontaktstellen der Leiterplatte elektrisch verbunden.

Wie aus Fig. 1 bis 6 weiter ersichtlich ist, weist das dargestellte Kontaktelement 5 einen Kontaktierbereich 5.4 auf, welcher seitlich über das Gehäuse 3 übersteht und mit einem elektrischen Leiter 9 kontaktiert werden kann. Somit können drei Kontaktelemente 5 eines als B6-Brückenschaltung ausgeführten Halbleitermoduls 1 jeweils über den Kontaktbereich 5.4 mit einem Phasenstromdraht der elektrischen Maschine elektrisch verbunden. Ein Endbereich 9.1 des elektrischen Leiters 9 bzw. Phasenstromdrahts kann beispielsweise mittels Löten, Widerstands- oder Laserschweißen, Schneid-Klemmung, Crimpen oder Einpressverbinden mit dem korrespondierenden Kontaktierbereich 5.4 verbunden werden. Um die freiliegenden Kontaktstellen 4.1 an der ersten Oberfläche 4 wärmetechnisch und stromtechnisch möglichst gut an die Kontaktelemente 5 und die metallischen Blöcke anzubinden, sind die Formen der Kontaktflächen 5.1 der Kontaktelements 5 und die Form der metallischen Blöcke jeweils an die Formen der jeweiligen freiliegenden Kontaktstelle 4.1 angepasst.

Bei einem alternativen nicht dargestellten Ausführungsbeispiel bildet ein abgewinkelter Endbereich eines elektrischen Leiters 9 unter Berücksichtigung von Zugentlastung und Montagetoleranzen das Kontaktelement 5 aus. Hierbei ist der elektrische Leiter 9 über eine dauerfeste Verbindungstechnologie direkt mit einer korrespondierenden Kontaktstelle 4.1 elektrisch verbunden und der Endbereich des elektrischen Leiters 9 weist ein ausreichendes Volumen auf, um als thermischer Speicher wirken zu können.

## Patentansprüche

1. Halbleitermodul (1) mit mindestens einem ersten und einem zweiten Halbleiterbauteil (10, 20), wobei das erste Halbleiterbauteil (10) als Low-Side-Schalttransistor und das zweite Halbleiterbauteil (20) als High-Side-Schalttransistor einer Halbbrückenschaltung ausgebildet sind und welche jeweils eine innerhalb eines Gehäuses (3) auf einem Träger (2) angeordnete aktive Halbleiterschicht (12, 22) aufweisen, wobei jeweils erste Elektroden (14, 24) der Halbleiterbauteile (10, 20) als Drain-Elektroden, zweite Elektroden (16, 26) der Halbleiterbauteile (10, 20) als Source-Elektroden und dritte Elektroden (18, 28) der Halbleiterbauteile (10, 20) als Gate-Elektroden ausgeführt sind, wobei ein Strompfad zwischen den mindestens zwei Halbleiterbauteilen (10, 20) mittels eines metallischen Verbindungsclips (30) ausgebildet ist, welcher die erste Elektrode (14) des ersten Halbleiterbauteils (10) mit der zweiten Elektrode (26) des zweiten Halbleiterbauteils (20) verbindet, wobei das erste Halbleiterbauteil (10) und das zweite Halbleiterbauteil (20) derart um 180° gedreht zueinander auf dem Träger (2) angeordnet sind, dass die zweite Elektrode (16) und die dritte Elektrode (18) des ersten Halbleiterbauteils (10) und die erste Elektrode (24) des zweiten Halbleiterbauteils (20) dem Träger zugewandt sind und die erste Elektrode (14) des ersten Halbleiterbauteils (10) und die zweite Elektrode (26) des zweiten Halbleiterbauteils (20) in einer gemeinsamen Ebene angeordnet sind, und wobei die erste Elektrode (14) des ersten Halbleiterbauteils (10) und die zweite Elektrode (26) des zweiten Halbleiterbauteils (20) jeweils mit einer ersten Clipseite (32) des metallischen Verbindungsclips (30) elektrisch verbunden sind und eine zweite Clipseite (34) des Verbindungsclips (30) eine freiliegende Kontaktstelle (4.1) ausbildet, wobei das Halbleitermodul außerhalb des Gehäuses (3) ein Kontaktelement (5) mit einer der Kontaktstelle (4.1) der zweiten Clipseite (34) zugewandten Kontaktfläche (5.1) aufweist, welche über eine elektrische leitende Verbindungschicht (5.3) dauerhaft mit der freiliegenden Kontaktstelle (4.1) der zweiten Clipseite (34) verbunden ist, **gekennzeichnet dadurch, dass** das Kontaktelement (5) dazu eingerichtet ist, einen zusätzlichen Hochstrompfad als Phasenpotentialabgriff der Halbrückenschaltung auszubilden, welcher vom Träger abgewandt ist.

2. Halbleitermodul (1) nach Anspruch 1, wobei das Kontaktelement (5) eine der Kontaktstelle (4.1) abgewandte Entwärmungsfläche (5.2) aufweist, welche mit einem Kühlkörper verbindbar ist.

3. Halbleitermodul (1) nach Anspruch 1 oder 2, wobei das Kontaktelement (5) eine als thermischer Speicher wirkende Wärmesenke ausbildet und ein Volumen aufweist, welches um einen Faktor von 5 bis 50 größer als ein Volumen des Verbindungsclips (30) ist.

4. Halbleitermodul (1) nach einem der vorhergehenden Ansprüche, wobei das Kontaktelement (5) einen Kontaktierbereich (5.4) aufweist, welcher seitlich über das Gehäuse (3) übersteht und mit einem elektrischen Leiter (9) kontaktierbar ist.

5. Halbleitermodul (1) nach Anspruch 4, wobei die Form der Kontaktfläche (5.1) des Kontaktelements (5) an die Form der freiliegenden Kontaktstelle (4.1) der zweiten Clipseite (34) des Verbindungsclips (30) angepasst ist.

6. Halbleitermodul (1) nach einem der Ansprüche 1 bis 3, wobei ein abgewinkelter Endbereich eines elektrischen Leiters (9) das Kontaktelement (5) ausbildet.

7. Halbleitermodul (1) nach einem der vorhergehenden Ansprüche, wobei das Gehäuse (3) als Moldgehäuse ausgeführt ist.

8. Halbleitermodul (1) nach einem der vorhergehenden Ansprüche, wobei die mindestens zwei Halbleiterbauteile (10, 20) als Leistungshalbleiterbauteile ausgeführt sind, welche den gleichen Flächenbedarf aufweisen.

9. Halbleitermodul (1) nach Anspruch 8, wobei drei Halbleiterbauteilpaare ein Brückenschaltungsmodul für drei Phasenstromdrähte einer elektrischen Maschine ausbilden.

10. Halbleitermodul (1) nach einem der vorhergehenden Ansprüche, wobei das Gehäuse (3) an seiner dem Träger abgewandten Oberfläche (4) mit einem Kühlkörper verbindbar ist, welcher auf mindestens einer Entwärmungsfläche (5.2) mindestens eines Kontaktelements (5) aufliegt.

11. Halbleitermodul (1) nach einem der vorhergehenden Ansprüche, wobei das Gehäuse (3) an seiner dem Kontaktelement (5) abgewandten Seite auf eine Leiterplatte aufgesetzt ist.

12. Kontaktanordnung umfassend ein Halbleitermodul (1) nach Anspruch 4 oder nach einem der Ansprüche 5, 7, 8, 9, 10 und 11, wenn er vom Anspruch 4 abhängig ist, wobei ein Endbereich (9.1) des elektrischen Leiters (9) mit dem Kontaktierbereich (5.4) des Kontaktelementes (5) mittels Löten, Widerstands- oder Laserschweißen, Scheid-Klemmung, Crimpen oder Einpressverbinden verbunden ist.

13. Kontaktanordnung nach Anspruch 12, wobei ein Phasenstromdraht einer elektrischen Maschine den elektrischen Leiter (9) ausbildet.

14. Kontaktanordnung nach Anspruch 12, wobei das Halbleitermodul auf einem Schaltungsträger angeordnet ist, wobei der Leiter (9) mit dem Phasenpotentialabgriff des Halbleitermodules (1) verbunden ist, ohne den Phasenstrom durch den Schaltungsträger zu führen.

## Claims

1. Semiconductor module (1) having at least one first and one second semiconductor component (10, 20), wherein the first semiconductor component (10) is in the form of a low-side switching transistor and the second semiconductor component (20) is in the form of a high-side switching transistor of a half-bridge circuit and each have an active semiconductor layer (12, 22) arranged within a housing (3) on a carrier (2), wherein first electrodes (14, 24) of the semiconductor components (10, 20) are configured as drain electrodes, second electrodes (16, 26) of the semiconductor components (10, 20) are configured as source electrodes, and third electrodes (18, 28) of the semiconductor components (10, 20) are configured as gate electrodes, wherein a current path between the at least two semiconductor components (10, 20) is formed by means of a metallic connection clip (30) which connects the first electrode (14) of the first semiconductor component (10) to the second electrode (26) of the second semiconductor component (20), wherein the first semiconductor component (10) and the second semiconductor component (20) are arranged on the carrier (2) in a manner rotated about 180° with respect to one another, the second electrode (16) and the third electrode (18) of the first semiconductor component (10) and the first electrode (24) of the second semiconductor component (20) face the carrier and the first electrode (14) of the first semiconductor component (10) and the second electrode (26) of the second semiconductor component (20) are arranged in a common plane, and wherein the first electrode (14) of the first semiconductor component (10) and the second electrode (26) of the second semiconductor component (20) are each electrically connected to a first clip side (32) of the metallic connection clip (30) and a second clip side (34) of the connection clip (30) forms an exposed contact point (4.1), wherein the semiconductor module outside the housing (3) has a contact element (5) having a contact surface (5.1) which faces the contact point (4.1) of the second clip side (34) and which is permanently connected via an electrical conductive connection layer (5.3) to the exposed contact point (4.1) of the second clip side (34), **characterized in that** the contact element (5) is set up to form an additional high-current path as a phase potential tap of the half-bridge circuit which faces away from the carrier.

2. Semiconductor module (1) according to Claim 1, wherein the contact element (5) has a heat-removal surface (5.2) which faces away from the contact point (4.1) and can be connected to a heat sink.

3. Semiconductor module (1) according to Claim 1 or 2, wherein the contact element (5) forms a heat sink acting as a thermal store and has a volume which is greater than a volume of the connection clip (30) by a factor of 5 to 50.

4. Semiconductor module (1) according to any one of the preceding claims, wherein the contact element (5) has a contact-connection area (5.4) which protrudes laterally beyond the housing (3) and can be contact-connected to an electrical conductor (9).

5. Semiconductor module (1) according to Claim 4, wherein the shape of the contact surface (5.1) of the contact element (5) is adapted to the shape of the exposed contact point (4.1) of the second clip side (34) of the connection clip (30).

6. Semiconductor module (1) according to any one of Claims 1 to 3, wherein an angled end region of an electrical conductor (9) forms the contact element (5).

7. Semiconductor module (1) according to any one of the preceding claims, wherein the housing (3) is embodied as a moulded housing.

8. Semiconductor module (1) according to any one of the preceding claims, wherein the at least two semiconductor components (10, 20) are embodied as power semiconductor components which have the same surface area requirement.

9. Semiconductor module (1) according to Claim 8, wherein three semiconductor component pairs form a bridge circuit module for three phase current wires of an electric machine.

10. Semiconductor module (1) according to any one of the preceding claims, wherein the housing (3) can be connected, at its surface (4) which faces away from the carrier, to a heat sink which rests on at least one heat-removal surface (5.2) of at least one contact element (5).

11. Semiconductor module (1) according to any one of the preceding claims, wherein the housing (3) is mounted, on its side facing away from the contact element (5), on a printed circuit board.

12. Contact arrangement comprising a semiconductor module (1) according to Claim 4 or according to any one of Claims 5, 7, 8, 9, 10 and 11 when dependent on Claim 4, wherein an end region (9.1) of the electrical conductor (9) is connected to the contact-connection region (5.4) of the contact element (5) by means of soldering, resistance or laser welding, insulationdisplacement connection, crimping or press-fit connection.

13. Contact arrangement according to Claim 12, wherein a phase current wire of an electric machine forms the electrical conductor (9).

14. Contact arrangement according to Claim 12, wherein the semiconductor module is arranged on a circuit carrier, wherein the conductor (9) is connected to the phase potential tap of the semiconductor module (1), without passing the phase current through the circuit carrier.

## Revendications

1. Module semi-conducteur (1) comprenant au moins un premier et un deuxième composants semi-conducteurs (10, 20), le premier composant semi-conducteur (10) étant conçu sous forme de transistor de commutation côté bas et le deuxième composant semi-conducteur (20) sous forme de transistor de commutation côté haut d'un circuit en demi-pont et présentant respectivement une couche semi-conductrice active (12, 22) disposée à l'intérieur d'un boîtier (3) sur un support (2), des premières électrodes (14, 24) des composants semi-conducteurs (10, 20) étant respectivement réalisées sous forme d'électrodes de drain, des deuxièmes électrodes (16, 26) des composants semi-conducteurs (10, 20), sous forme d'électrodes de source et des troisièmes électrodes (18, 28) des composants semi-conducteurs (10, 20), sous forme d'électrodes de grille, un trajet de courant entre les au moins deux composants semi-conducteurs (10, 20) étant réalisé au moyen d'un clip de raccordement métallique (30) qui relie la première électrode (14) du premier composant semi-conducteur (10) à la deuxième électrode (26) du deuxième composant semi-conducteur (20), le premier composant semi-conducteur (10) et le deuxième composant semi-conducteur (20) étant disposés en étant tournés de 180° l'un par rapport à l'autre sur le support (2) de telle sorte que la deuxième électrode (16) et la troisième électrode (18) du premier composant semi-conducteur (10) et la première électrode (24) du deuxième composant semi-conducteur (20) soient tournées vers le support et que la première électrode (14) du premier composant semi-conducteur (10) et la deuxième électrode (26) du deuxième composant semi-conducteur (20) soient disposées dans un plan commun, et la première électrode (14) du premier composant semi-conducteur (10) et la deuxième électrode (26) du deuxième composant semi-conducteur (20) étant respectivement connectées électriquement à une première face de clip (32) du clip de raccordement métallique (30) et une deuxième face de clip (34) du clip de raccordement (30) formant un point de contact exposé (4.1), le module semi-conducteur présentant à l'extérieur du boîtier (3) un élément de contact (5) ayant une surface de contact (5.1) tournée vers le point de contact (4.1) de la deuxième face de clip (34) et reliée de manière permanente au point de contact exposé (4.1) de la deuxième face de clip (34) par l'intermédiaire d'une couche de connexion électriquement conductrice (5.3), **caractérisé en ce que** l'élément de contact (5) est conçu pour réaliser un trajet de courant à haute intensité supplémentaire, tourné à l'opposé du support, sous forme de prise de potentiel de phase du circuit en demi-pont.

2. Module semi-conducteur (1) selon la revendication 1, dans lequel l'élément de contact (5) présente une surface de dissipation thermique (5.2) tournée à l'opposé du point de contact (4.1) et pouvant être reliée à un dissipateur thermique.

3. Module semi-conducteur (1) selon la revendication 1 ou 2, dans lequel l'élément de contact (5) constitue un puits thermique agissant comme accumulateur thermique et présente un volume qui est supérieur d'un facteur de 5 à 50 au volume du clip de raccordement (30).

4. Module semi-conducteur (1) selon l'une quelconque des revendications précédentes, dans lequel l'élément de contact (5) présente une zone de contact (5.4) qui dépasse latéralement du boîtier (3) et peut être mise en contact avec un conducteur électrique (9).

5. Module semi-conducteur (1) selon la revendication 4, dans lequel la forme de la surface de contact (5.1) de l'élément de contact (5) est adaptée à la forme du point de contact exposé (4.1) de la deuxième face de clip (34) du clip de raccordement (30).

6. Module semi-conducteur (1) selon l'une quelconque des revendications 1 à 3, dans lequel une zone d'extrémité coudée d'un conducteur électrique (9) constitue l'élément de contact (5).

7. Module semi-conducteur (1) selon l'une quelconque des revendications précédentes, dans lequel le boîtier (3) est réalisé sous forme de boîtier moulé.

8. Module semi-conducteur (1) selon l'une quelconque des revendications précédentes, dans lequel les au moins deux composants semi-conducteurs (10, 20) sont réalisés sous forme de composants semi-conducteurs de puissance qui présentent le même encombrement.

9. Module semi-conducteur (1) selon la revendication 8, dans lequel trois paires de composants semi-conducteurs forment un module de circuit en pont pour trois fils de courant de phase d'une machine électrique.

10. Module semi-conducteur (1) selon l'une quelconque des revendications précédentes, dans lequel le boîtier (3) peut être relié au niveau de sa surface (4) tournée à l'opposé du support à un dissipateur thermique qui repose sur au moins une surface de dissipation thermique (5.2) d'au moins un élément de contact (5).

11. Module semi-conducteur (1) selon l'une quelconque des revendications précédentes, dans lequel le boîtier (3) est posé par sa face tournée à l'opposé de l'élément de contact (5) sur une carte de circuits imprimés.

12. Agencement de contact comprenant un module semi-conducteur (1) selon la revendication 4 ou selon l'une quelconque des revendications 5, 7, 8, 9, 10 et 11 lorsqu'elle dépend de la revendication 4, dans lequel une zone d'extrémité (9.1) du conducteur électrique (9) est reliée à la zone de contact (5.4) de l'élément de contact (5) par brasage, par soudage par résistance ou au laser, par raccord à borne guillotine, par sertissage ou par emmanchement.

13. Agencement de contact selon la revendication 12, dans lequel un fil de courant de phase d'une machine électrique constitue le conducteur électrique (9).

14. Agencement de contact selon la revendication 12, dans lequel le module semi-conducteur est disposé sur un support de circuit, le conducteur (9) étant relié à la prise de potentiel de phase du module semi-conducteur (1) sans faire passer le courant de phase à travers le support de circuit.
